Europäisches Patentamt

European Patent Office

Office européen des brevets

(19)

(11) Veröffentlichungsnummer: **0 136 642**
**B1**

(12) **EUROPÄISCHE PATENTSCHRIFT**

(45) Veröffentlichungstag der Patentschrift:
**01.06.88**

(21) Anmeldenummer: **84111368.1**

(22) Anmeldetag: **24.09.84**

(51) Int. Cl.⁴: **G 01 N 24/02**, G 01 N 24/08

(54) **Gerät zur Erzeugung von Bildern eines Untersuchungsobjektes.**

(30) Priorität: **05.10.83 DE 3336254**

(43) Veröffentlichungstag der Anmeldung:
**10.04.85 Patentblatt 85/15**

(45) Bekanntmachung des Hinweises auf die Patenterteilung:
**01.06.88 Patentblatt 88/22**

(84) Benannte Vertragsstaaten:
**DE FR GB NL**

(56) Entgegenhaltungen:
**EP - A - 0 071 896
DE - A - 1 773 742
DE - A - 2 409 947**

**REVIEW OF SCIENTIFIC INSTRUMENTS, Band 52, Nr. 4,
April 1981, Seiten 542-547, American Institute of
Physics, New York, US; J. BRONDEAU u.a.: "Flexible
fourier multinuclear magnetic resonance
spectrometer"**

(73) Patentinhaber: **Siemens Aktiengesellschaft Berlin und
München, Wittelsbacherplatz 2, D-8000 München 2 (DE)**

(72) Erfinder: **Kess, Helmut, Hopfenstrasse 28,
D-8360 Deggendorf (DE)**

## Beschreibung

Die Erfindung betrifft ein Gerät zur Erzeugung von Bildern eines Untersuchungsobjektes mit magnetischer Kernresonanz, bei dem Mittel zum Anlegen von magnetischen Grund- und Gradientenfeldern an das Untersuchungsobjekt und zum Erfassen der Auslenkung der Atomkerne des Untersuchungsobjektes aus ihrer Gleichgewichtslage durch einen hochfrequenten, magnetischen Anregeimpuls vorhanden sind.

Aus der EP-A-00 71 896 ist eine Einrichtung der Kernspin-Resonanz-Technik bekannt, bei der durch rechnerische oder meßtechnische Analyse integraler Protonenresonanzsignale aus der räumlichen Spindichte- und/oder Relaxationszeitenverteilung eines zu untersuchenden Körpers ein Bild ähnlich einem Röntgen-Diagramm konstruiert wird. Dabei wird der zu untersuchende Körper in ein starkes homogenes Magnetfeld eingebracht. Dieses als Grundfeld dienende Magnetfeld ist von stationären und/oder gepulsten Gradientenfeldern überlagert. Außerdem ist ein senkrecht zu dem Grundfeld angeordnetes Hochfrequenzwechselfeld vorgesehen, das ebenfalls möglichst homogen ist. Dieses Hochfrequenzwechselfeld dient dazu, die Kernspin-Magnetisierung des zu untersuchenden, insbesondere menschlichen Körpers aus der Gleichgewichtsrichtung zu klappen. Eine Komponente der so erzeugten Magnetisierung präzediert um die Richtung des Grundfeldes und induziert in einer Aufnehmerspule ein elektrisches Signal, welches verstärkt und ausgewertet wird.

Aus der DE-A-1 773 742 ist ein Spektrometer mit einem Pendelrückkoppelungsdetektor bekannt. Der Pendelrückkoppelungsdetektor enthält einen Hochfrequenzoszillator. Die Änderung der Oszillatorfrequenz wird durch einen Kippmotor, welcher eine veränderliche Kapazität im Schwingkreis des Oszillators steuert, geändert.

Es ist bekannt, daß man insbesondere die Wasserstoffatomkerne eines Untersuchungsobjektes aus einer Vorzugsrichtung, die durch ein Magnet-Grundfeld erzeugt wird, durch einen hochfrequenten Anregungsimpuls auslenken kann und daß sich die Atomkerne nach dem Ende dieses Anregungsimpulses aufgrund ihrer Spins erst nach einer gewissen Zeit wieder in die Vorzugsrichtung einpendeln. Während dieser Zeit präzedieren die Atomkerne mit einer Frequenz, die von der Stärke des Magnet-Grundfeldes abhängt. Überlagert man diesem homogenen Magnet-Grundfeld einen Feldgradienten, so daß die Magnetfeldverteilung räumlich variiert, so ist eine Ortung über die jeweils gemessene Frequenz möglich. Es ist auch bekannt, daß man auf diese Weise und durch Änderung der Richtung des Feldgradienten Schichtbilder des Untersuchungsobjektes anfertigen kann. Die Anregung in einer Schicht des Untersuchungsobjektes erfolgt dabei dadurch, daß das Magnet-Grundfeld durch einen weiteren Feldgradienten so beeinflußt wird, daß nur in dieser Schicht eine Anregung der Atomkerne erfolgt. Dies ist möglich, weil die Anregung nur mit einer Frequenz erfolgt, die dem Magnetfeld in der gewünschten Schicht streng zugeordnet ist.

Bei Geräten der eingangs genannten Art ist es erforderlich, die Resonanz der Meß- und Anregungsspule exakt einzustellen. Hierzu kann die jeweilige Spule mit einer Kondensatoranordnung zusammengeschaltet werden, wobei die Kondensatoranordnung dann der gewünschten Frequenz entsprechend abgestimmt wird. Hierzu können Drehkondensatoren Verwendung finden. Die in dieser Weise abzustimmenden Spulen liegen im Inneren des Grundfeldmagneten. Für eine Verstellung von Drehkondensatoren müssen daher Elektromotoren ebenfalls im Inneren des Grundfeldmagneten angeordnet werden. Hierzu eignen sich aber nicht die üblichen Motoren mit Eisenkernen, da sie in dem relativ starken Feld des Grundfeldmagneten nicht funktionsfähig sind.

Der Erfindung liegt die Aufgabe zugrunde, ein Gerät der eingangs genannten Art so auszubilden, daß eine einfache motorische Verstellung veränderbarer Bauelemente, z.B. von Kondensatoren, im Feld des Grundfeldmagneten möglich ist.

Diese Aufgabe ist erfindungsgemäß dadurch gelöst, daß im Grundfeldmagneten ein eisenloser Gleichstrommotor mit seinem Rotor so angeordnet ist, daß die Rotordrehung aufgrund des als Statorfeld benutzten Grundfeldes zustande kommt. Die Erfindung geht von der Erkenntnis aus, daß bei einem eisenlosen Gleichstrommotor das relativ starke Feld des Grundfeldmagneten bei entsprechender Ausbildung und Anordnung des Rotors als Statorfeld genutzt werden kann.

Die Erfindung ist nachfolgend anhand eines in der Zeichnung dargestellten Ausführungsbeispieles näher erläutert.

Es zeigen:

Fig. 1 eine Darstellung eines Gerätes der eingangs genannen Art zur Erläuterung der Erfindung,

Fig. 2 eine Schaltung zur Abstimmung der Induktivität einer Anregungs- und Meßspule, und

Fig. 3 eine Anordnung für diese Abstimmung.

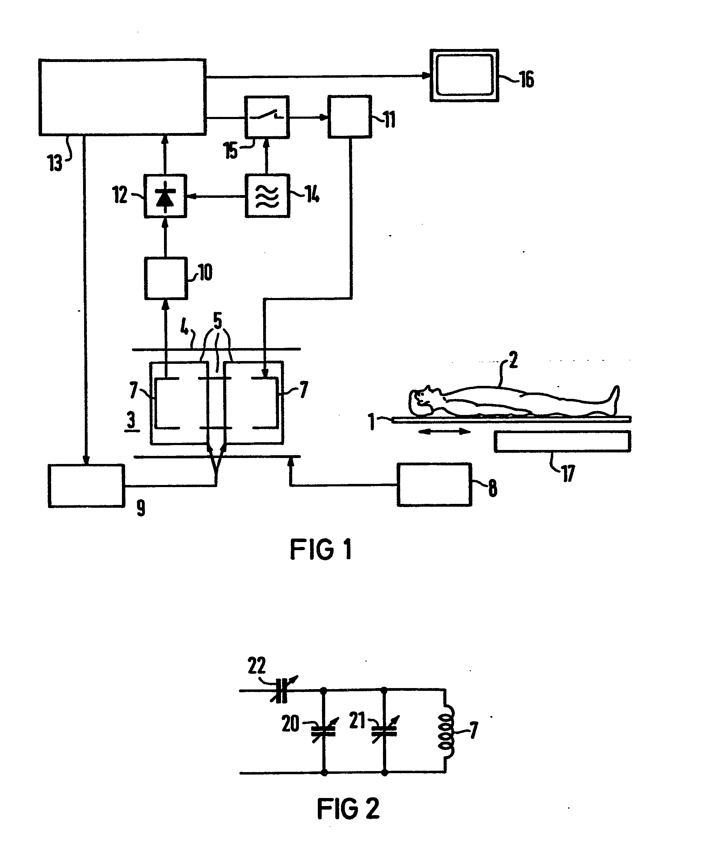

In der Fig. 1 ist eine Auflage 1 dargestellt, auf der ein Patient 2 liegt, von dem mit Hilfe magnetischer Kernresonanz Bilder erzeugt werden sollen. Hierzu sind ein Spulensystem 3 mit einer Spule 4 zur Erzeugung eines homogenen Magnet-Grundfeldes, Gradientenspulen 5 zur Variierung dieses Magnetfeldes sowie mit einer Anregungs- und Meßspule 7 vorhanden. Die Spule 4 ist an einer Magnet-Stromversorgung 8, die Gradientenspulen 5 sind an einer Gradienten-Stromversorgung 9, die Anregungs- und Meßspule 7 ist an einem Vorverstärker 10 und über entsprechende Koppelelemente an einem Sendeverstärker 11 angeschlossen. Der Vorverstärker 10 führt das Meßsignal über einen phasenempfindlichen Gleichrichter 12 einem Prozeßrechner 13 zu, der den gesamten Meßvorgang steuert. Zur Erzeugung eines Anregungsimpulses dient ein Hochfrequenzoszillator 14, der über einen Modulator 15 an den Sendeverstärker 11 anschaltbar ist. Die Wiedergabe der erzeugten Bilder erfolgt auf einem Monitor 16.

Zur Erzeugung eines Bildes des Patienten 2 mit Hilfe magnetischer Kernresonanz wird die Auflage 1 mit Hilfe einer Steuervorrichtung 17, die ebenfalls vom Prozeßrechner 13 angesteuert wird, so in das Spulensystem 3 eingeschoben, daß eine gewünschte Schicht des Patienten 2 so liegt, daß aufgrund des erzeugten Magnetfeldes dort durch einen Anregungsimpuls in der Spule 7 Kernresonanz angeregt wird. Aus dem ebenfalls mit der Spule 7 aufgenommenen Meßsignal werden bei unterschiedlichen Feldgradienten Informationen gebildet, die die bildliche Wiedergabe der untersuchten Schicht des Patienten 2 auf dem Monitor 16 ermöglichen.

Die Fig. 2 zeigt, wie die Resonanz der Spule 7 exakt abgestimmt werden kann. Hierzu sind parallel zur Spule 7 zwei Drehkondensatoren 20 und 21 geschaltet, und in Reihe zu dieser Parallelschaltung liegt ein Drehkondensator 22.

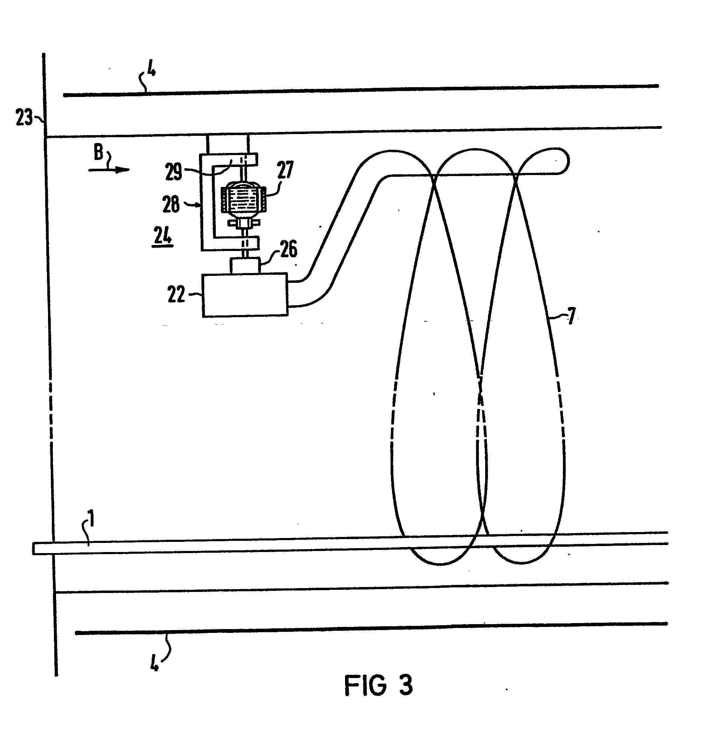

Die Fig. 3 zeigt das Innere des Gerätes gemäß der Fig. 1 schematisch. Die Spule 4 zur Erzeugung des Magnet-Grundfeldes ist in einem Gehäuse 23 angeordnet, das einen rohrförmigen Hohlraum 24 begrenzt, in den der Patient 2 auf der Liege 1 eingeschoben wird. Die Spule 7 umschließt dabei, wie auch die weiteren in der Fig. 1 dargestellten Spulen, den Patienten 2. Sie ist elektrisch mit dem Kondensator 22 verbunden, der über ein Getriebe 26 vom Rotor 27 eines eisenlosen Gleichstrommotors 28 verstellbar ist. Der Rotor 27 ist in einem Bügel 29, der am Gehäuse 23 befestigt ist, drehbar gelagert und läßt das in Pfeilrichtung B verlaufende Grundfeld der Spule 4 auf die Spulen des Rotors 27 als Statorfeld einwirken. Demgemäß ist eine einwandfreie Funktion des Motors 28 gegeben.

In analoger Weise werden über weitere Motoren die Kondensatoren 20 und 21 verstellt. Die Komponenten 22 sowie 26 bis 29 sind in der Fig. 3 der Übersichtlichkeit halber vergrößert gezeichnet. In der Praxis werden sie die Einführung des Patienten nicht behindern.

**Patentanspruch**

1. Gerät zur Erzeugung von Bildern eines Untersuchungsobjektes (2) mit magnetischer Kernresonanz, bei dem Mittel (3) zum Anlegen von magnetischen Grund- und Gradientenfeldern an das Untersuchungsobjekt (2) und zum Erfassen der Auslenkung der Atomkerne des Untersuchungsobjektes (2) aus ihrer Gleichgewichtslage durch einen hochfrequenten, magnetischen Anregungsimpuls vorhanden sind, dadurch gekennzeichnet, daß im Grundfeldmagneten (4) ein eisenloser Gleichstrommotor (28) mit seinem Rotor (27) so angeordnet ist, daß die Rotordrehung aufgrund des als Statorfeld benutzten Grundfeldes (B) zustande kommt.

**Claim**

1. A device for producing images of an object (2) under examination using magnetic nuclear resonance, wherein means (3) are provided for connecting fundamental and gradient magnetic fields to the object (2) under examination and for detecting deflection of the atomic cores of the object (2) under examination out of their state of equilibrium, using a high-frequency, magnetic excitation pulse, characterised in that in the fundamental field magnet (4) the rotor (27) of an ironless d.c. motor (28) is arranged such that rotor rotation results due to the fundamental field (B) which is used as stator field.

**Revendication**

1. Appareil pour produire des images d'un objet examiné (2) moyennant l'utilisation de la résonance magnétique nucléaire et dans lequel il est prévu des moyens (3) servant à appliquer un champ de base magnétique et des champs magnétiques irrotationnels à l'objet examiné (2) et pour enregistrer la déviation des noyaux atomiques de l'objet examiné (2) à partir de leur position d'équilibre, sous l'effet d'une impulsion d'excitation magnétique à haute fréquence, caractérisé par le fait que le rotor (27) d'un moteur à courant continu (28) sans fer est disposé dans l'aimant (4) produisant le champ de base de telle sorte que la rotation du rotor s'effectue sous l'action du champ de base (B) utilisé comme champ statorique.

FIG 1

FIG 2

FIG 3